(19) Europäisches Patentamt / European Patent Office / Office européen des brevets

(11) **EP 3 384 595 B1**

(12) **FASCICULE DE BREVET EUROPEEN**

(45) Date de publication et mention de la délivrance du brevet:
**11.09.2019 Bulletin 2019/37**

(21) Numéro de dépôt: **16806042.4**

(22) Date de dépôt: **01.12.2016**

(51) Int Cl.:
*H02S 50/00* $^{(2014.01)}$    *H02S 50/10* $^{(2014.01)}$

(86) Numéro de dépôt international:
**PCT/EP2016/079469**

(87) Numéro de publication internationale:
**WO 2017/093423 (08.06.2017 Gazette 2017/23)**

(54) **PROCÉDÉ ET DISPOSITIF D'ÉVALUATION DE L'ÉNERGIE PRODUITE PAR UN ARC ELECTRIQUE DANS UNE INSTALLATION PHOTOVOLTAÏQUE**

VERFAHREN UND VORRICHTUNG ZUR BEURTEILUNG DER VON EINEM LICHTBÖGEN IN EINER FOTOVOLTAIKANLAGE ERZEUGTEN ENERGIE

METHOD AND DEVICE FOR EVALUATING THE ENERGY PRODUCED BY AN ELECTRIC ARC IN A PHOTOVOLTAIC INSTALLATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.12.2015 FR 1561623**

(43) Date de publication de la demande:
**10.10.2018 Bulletin 2018/41**

(73) Titulaires:
- **Commissariat à l'Énergie Atomique et aux Énergies Alternatives**
  **75015 Paris (FR)**
- **Socomec**
  **67230 Benfeld (FR)**

(72) Inventeurs:
- **CHAINTREUIL, Nicolas**
  **73800 Montmelian (FR)**
- **SIAT, Stéphane**
  **67230 Obenheim (FR)**

(74) Mandataire: **Novaimo**
**ActiTech 8**
**60 avenue Marie Curie**
**Archamps Technopole**
**74166 Saint Julien-en-Genevois Cedex (FR)**

(56) Documents cités:
**US-A1- 2011 267 721    US-A1- 2012 134 058**

- XIU YAO ET AL: "The detection of DC arc fault: Experimental study and fault recognition", APPLIED POWER ELECTRONICS CONFERENCE AND EXPOSITION (APEC), 2012 TWENTY-SEVENTH ANNUAL IEEE, IEEE, 5 février 2012 (2012-02-05), pages 1720-1727, XP032127899, DOI: 10.1109/APEC.2012.6166054 ISBN: 978-1-4577-1215-9
- KOSTYANTYN KOZIY ET AL: "A Low-Cost Power-Quality Meter With Series Arc-Fault Detection Capability for Smart Grid", IEEE TRANSACTIONS ON POWER DELIVERY, IEEE SERVICE CENTER, NEW YORK, NY, US, vol. 28, no. 3, 1 juillet 2013 (2013-07-01), pages 1584-1591, XP011515987, ISSN: 0885-8977, DOI: 10.1109/TPWRD.2013.2251753
- SCHIMPF F ET AL: "Recognition of electric arcing in the DC-wiring of photovoltaic systems", INTELEC 09 : 31ST INTERNATIONAL TELECOMMUNICATIONS ENERGY CONFERENCE ; INCHEON, KOREA, 18 - 22 OCTOBER 2009, IEEE, PISCATAWAY, NJ, USA, 18 octobre 2009 (2009-10-18), pages 1-6, XP031579534, ISBN: 978-1-4244-2490-0

**EP 3 384 595 B1**

**Description**

**Domaine technique de l'invention**

L'invention concerne un procédé et un dispositif d'évaluation de l'énergie produite par un arc électrique dans une installation photovoltaïque. Elle concerne aussi une installation photovoltaïque équipée d'un tel dispositif.

**État de la technique**

Les installations photovoltaïques sont susceptibles d'être le siège d'arcs électriques. Les documents X. Yao et al.,Applied Power Electronics Conférence and Exhibition, 2012, Twenty-seventh annual IEEE, 1720-1727, XP032127899A, et K. Koziz et al., IEEE Transactions on Power Delivery, V. 28, n.3, 1584-1591, (2013), décrivent des systèmes d'évaluation pour installations photovoltaïques.

Un arc électrique peut se produire en cas de défaut de conducteur ou en cas de connexion défectueuse (par exemple suite à l'ouverture d'un connecteur en charge ou du fait de la corrosion d'un conducteur). Il est réalisé par un plasma qui apparaît entre deux électrodes. Celles-ci peuvent être constituées par les deux extrémités d'un conducteur ou par deux parties d'un connecteur ouvert ou localement interrompu (du fait d'une corrosion par exemple). L'apparition d'un arc électrique s'accompagne d'un front ou saut positif de tension de courte durée, de l'ordre de quelques microsecondes. La tension d'arc initiale $V_{arc0}$ a une valeur qui est caractéristique de l'apparition d'un arc électrique et qui dépend du matériau des électrodes. Elle est généralement comprise entre 10V et 30V. Par exemple, dans le cas d'électrodes en cuivre, la tension d'arc initiale $V_{arc0}$ est de l'ordre de 20V. Le plasma de l'arc électrique joue le rôle d'une résistance qui augmente au cours du temps. Le front de tension initial est donc généralement suivi d'une augmentation progressive de la tension d'arc pouvant aller jusqu'à atteindre une tension en circuit ouvert.

Les installations photovoltaïques ont la caractéristique de fonctionner à courant et tension électriques continues, ce qui peut s'avérer problématique en cas d'apparition d'un arc électrique lié à un défaut. En effet, en courant et tension continus, il n'y a pas d'extinction naturelle de l'arc électrique par passage par zéro de la tension et du courant, comme c'est le cas en courant alternatif. Il en résulte qu'un arc électrique lié à un défaut est susceptible de générer un plasma dégageant une très forte chaleur pendant une durée importante et produisant donc beaucoup d'énergie au sein d'une installation photovoltaïque. Un tel plasma est destructeur et peut provoquer un début d'incendie. Pour des raisons de sécurité, il est donc indispensable de détecter la présence d'un éventuel arc électrique au sein d'une installation photovoltaïque et de l'interrompre en temps utile afin d'éviter toute dégradation ou début d'incendie. A cet effet, l'installation photovoltaïque est équipée d'un dispositif de détection d'arc, ou détecteur d'arc. Celui-ci est généralement associé à un dispositif d'intervention ou d'extinction d'arc, destiné à intervenir pour interrompre l'arc électrique et empêcher toute dégradation ou départ d'incendie.

Un arc électrique peut également se produire, en fonctionnement normal, dans un organe électromagnétique de commande et/ou de protection, à l'ouverture ou à la fermeture de contacts ou pôles. Par exemple, un interrupteur sectionneur génère, à l'ouverture, un arc électrique d'une durée inférieure ou égale à une durée maximale connue. Des moyens d'extinction d'arc permettent généralement d'interrompre l'arc de manière à ce qu'il ne perdure pas au-delà d'une durée d'arc maximale prédéfinie.

Il existe diverses méthodes, dont certaines très rapides, permettant de détecter la présence d'un arc électrique dans une installation photovoltaïque. En cas d'arc électrique lié à l'ouverture en charge d'un interrupteur sectionneur ou autre organe électromécanique, cela risque de provoquer une détection positive d'arc suivie d'un arrêt intempestif de l'installation photovoltaïque, ce qui n'est pas souhaitable.

Par ailleurs, un arc électrique lié à un défaut dans l'installation photovoltaïque peut avoir une durée pouvant aller de quelques microsecondes à plusieurs minutes, voire plusieurs heures dans certaines conditions particulières. Par exemple, dans le cas d'un arc électrique discontinu composé d'une succession de micro-arcs de courtes durées, séparés par des périodes sans arc, chaque micro-arc n'est a priori pas dangereux en lui-même mais l'énergie cumulée par la succession de ces micro-arcs peut devenir critique pour l'environnement et/ou l'installation au fil du temps.

Pour les raisons qui viennent d'être évoquées, il apparaît utile d'évaluer le niveau d'énergie électrique généré par un arc électrique, dans le but notamment d'apprécier sa dangerosité pour l'installation photovoltaïque et/ou l'environnement.

**Objet de l'invention**

A cet effet, l'invention concerne un procédé d'évaluation de l'énergie électrique produite par un arc électrique dans une installation photovoltaïque comprenant les étapes suivantes :

A) Mesure d'un signal de tension électrique aux bornes d'au moins un module photovoltaïque de l'installation avec une fréquence d'échantillonnage supérieure ou égale à 50 kHz et, à partir du signal de tension mesuré :

- o Détermination d'une tension initiale avant apparition de l'arc ;
- o Détermination de valeurs de tension pendant l'arc électrique ;

B) Evaluation de valeurs de courant électrique produit par l'installation photovoltaïque pendant l'arc électrique ;
C) Intégration dans le temps du produit de valeurs de tension d'arc égales à la différence entre les valeurs de tension pendant l'arc et la tension initiale, déterminées lors de l'étape A), par des valeurs de courant évaluées lors de l'étape B), afin de déterminer l'énergie de l'arc.

Selon l'invention, l'énergie d'arc, c'est-à-dire l'énergie électrique générée par un arc électrique se produisant au sein de l'installation photovoltaïque, est évaluée de façon simple à partir de la tension aux bornes d'un ou plusieurs modules photovoltaïques de l'installation, mesurée avec une fréquence d'échantillonnage élevée.
Dans un mode de réalisation particulier, pour évaluer une valeur de courant pendant l'arc, on détermine un courant électrique initial avant l'arc électrique et on soustrait audit courant initial une valeur de tension d'arc, égale à la différence entre une valeur de tension déterminée lors de l'étape A) et la tension initiale, multipliée par le rapport entre l'amplitude d'un saut de courant lié à l'apparition de l'arc et l'amplitude d'un saut de tension lié à l'apparition de l'arc. Ainsi, après apparition de l'arc, on considère que le courant varie de façon linéaire en fonction de la tension. Avantageusement, l'amplitude du saut de courant est égale à un pourcentage prédéfini de x% du courant initial, x étant compris entre 6% et 8%, notamment égal à 7%.
La valeur du saut de tension peut être prédéfinie et comprise entre 12V et 35V, par exemple égale à 20V.
Dans une variante de réalisation, les valeurs de courant pendant l'arc évaluées sont des valeurs mesurées avec une fréquence d'échantillonnage inférieure ou égale à 1 Hz.
Avantageusement, le procédé comprend une étape de décomposition du signal de tension en une pluralité de fenêtres d'acquisition, chaque fenêtre contenant un nombre $N_f$ de points d'acquisition correspondant à des valeurs de tension échantillonnées, et, pour chaque fenêtre d'acquisition, une étape de détermination d'une valeur moyenne de la tension mesurée sur ladite fenêtre.
Avantageusement encore, on détermine la tension initiale avant apparition de l'arc en calculant une moyenne d'une pluralité de valeurs moyennes de tension relatives à une pluralité de fenêtres d'acquisition avant l'arc électrique.
Dans un premier mode de réalisation particulier, les valeurs de tension déterminées pendant l'arc électrique sont égales à des valeurs moyennes de tension relative à une succession de fenêtres d'acquisition.
Dans un deuxième mode de réalisation particulier, on calcule :

- une tension d'arc moyenne V<sub>arctot</sub>, en calculant la moyenne d'une pluralité de valeurs de tension d'arc déterminées relatives à une pluralité n de fenêtres d'acquisition couvrant l'arc électrique,
- un courant moyen I<sub>arctot</sub> pendant l'arc électrique, en calculant la moyenne d'une pluralité de valeurs de courant évaluées pour la pluralité n de fenêtres d'acquisition ;
- l'énergie totale produite par l'arc E<sub>arctot</sub> par la relation : $E_{arctot} = V_{arctot} \times I_{arctot} \times n \times \frac{1}{F_{ech}} \times N_f$ où n, F<sub>ech</sub> et $N_f$ représentent respectivement le nombre de fenêtres d'acquisition pendant l'arc, la fréquence d'échantillonnage de la tension mesurée et le nombre de points d'acquisition dans une fenêtre d'acquisition.

Dans un troisième mode de réalisation, on calcule :

- l'énergie d'arc produite par l'arc pendant chaque fenêtre d'acquisition d'indice arcj par la relation $E_{Farcj} = V_{arcj} \times I_{Farcj} \times \frac{1}{F_{ech}} \times N_f$ où $V_{arcj}$, $I_{Farcj}$, $F_{ech}$ et $N_f$ représentent respectivement une tension d'arc moyenne calculée pour la fenêtre d'indice arcj, un courant moyen évalué pour la fenêtre d'indice arcj, la fréquence d'échantillonnage de la tension mesurée et le nombre de points d'acquisition dans une fenêtre d'acquisition ;
- l'énergie totale produite par l'arc E<sub>arctot</sub> en faisant la somme des énergies d'arc produites sur une pluralité n de fenêtres d'acquisition couvrant l'arc électrique.

Avantageusement, dans le cas d'un arc électrique discontinu comportant une pluralité de micro-arcs, on détermine l'énergie de chaque micro-arc électrique, puis on fait la somme des énergies respectives des micro-arcs électriques afin de déterminer l'énergie de l'arc électrique discontinu.
Avantageusement encore, le procédé comprend une étape de comparaison de l'énergie de l'arc électrique déterminée avec un seuil d'énergie et une étape de mise en sécurité en cas de dépassement dudit seuil.

L'invention concerne aussi un dispositif d'évaluation de l'énergie dégagée par un arc électrique dans une installation photovoltaïque caractérisé en ce qu'il comprend :

- un module d'obtention d'un signal de tension électrique mesuré aux bornes d'au moins un module photovoltaïque de l'installation avec une fréquence d'échantillonnage supérieure ou égale à 50 kHz ;
- un module de détermination d'un courant électrique initial produit par l'installation photovoltaïque avant apparition de l'arc ;
- un module de traitement du signal de tension adapté pour déterminer, à partir du signal de tension mesuré :

     o une tension initiale avant apparition de l'arc ;
     o des valeurs de tension pendant l'arc électrique ;

- un module d'évaluation de valeurs de courant électrique produit par l'installation photovoltaïque pendant l'arc électrique;
- un module d'intégration dans le temps du produit de valeurs de tension d'arc égales à la différence entre les valeurs de tension pendant l'arc et la tension initiale déterminées par le module de traitement, par des valeurs de courant évaluées par le module d'évaluation, afin de déterminer l'énergie de l'arc.

L'invention concerne encore un système de sécurité pour une installation photovoltaïque, caractérisé en ce qu'il comprend un dispositif de détection d'un arc électrique, un dispositif d'évaluation de l'énergie électrique produite par un arc électrique détecté, tel que défini ci-dessus, et un dispositif d'intervention destiné à mettre l'installation photovoltaïque en sécurité.

L'invention concerne enfin une installation photovoltaïque comportant un tel système de sécurité.

**Description sommaire des dessins**

L'invention sera mieux comprise à l'aide de la description suivante d'un mode de réalisation particulier du procédé et du dispositif d'évaluation de l'énergie électrique produite ou générée par un arc électrique dans une installation photovoltaïque, d'un système de sécurité pour installation photovoltaïque intégrant un tel dispositif d'évaluation et d'une installation photovoltaïque équipée de ce système de sécurité, en référence aux dessins annexés sur lesquels :

- La figure 1 représente un schéma d'une installation photovoltaïque selon un exemple de réalisation de l'invention ;
- La figure 2 représente un exemple de signal mesuré de la tension électrique aux bornes d'un ou plusieurs modules photovoltaïques de l'installation de la figure 1, intégrant un saut de tension lié à l'apparition d'un arc électrique et décomposé en fenêtres d'acquisition ;
- La figure 3 représente un deuxième exemple d'un signal de tension électrique aux bornes d'un ou plusieurs modules photovoltaïques de l'installation de la figure 1, intégrant un saut de tension lié à l'apparition d'un arc électrique discontinu ;
- La figure 4 représente un exemple de la caractéristique courant-tension d'un module photovoltaïque de l'installation de la figure 1 et la courbe correspondante de puissance en fonction de la tension ;
- La figure 5 représente un organigramme des étapes du procédé d'évaluation, selon un mode de réalisation particulier de l'invention ;

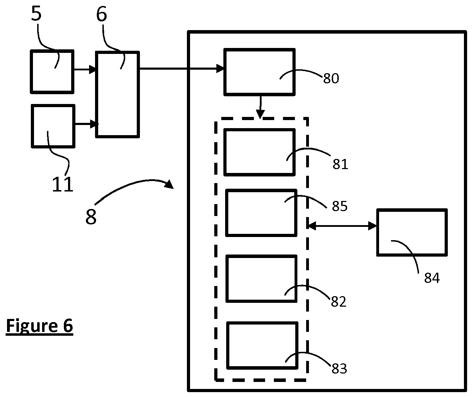

- La figure 6 représente un schéma bloc fonctionnel du dispositif d'évaluation selon une forme de réalisation particulière de l'invention, adapté pour mettre en oeuvre le procédé de la figure 5.

**Description détaillée de modes de réalisation particuliers de l'invention**

L'invention vise à évaluer l'énergie électrique générée ou produite par un arc électrique se produisant au sein d'une installation photovoltaïque 100.

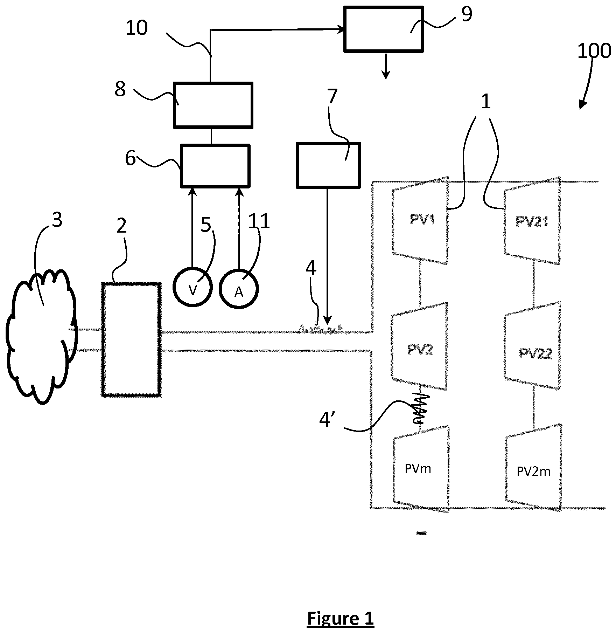

Sur la figure 1, on a représenté schématiquement un exemple d'installation photovoltaïque 100 apte à produire un courant continu I. Celle-ci comprend, de façon connue, plusieurs modules photovoltaïques (PV) 1 reliés à un onduleur 2. Les modules PV 1 sont ici identiques. Les modules PV1 peuvent être montés en série, en parallèle ou en combinant les deux. Une chaîne de modules PV montés en série est appelée « string ». Par exemple, comme représenté sur la figure 1, l'installation 100 comprend plusieurs strings, ou chaînes, de m modules PV 1, connectées en parallèle. L'onduleur 2 est destiné à convertir le courant continu I produit par les modules photovoltaïques 1 en un courant alternatif et à fournir celui-ci à un réseau électrique 3.

Le procédé de l'invention cherche à évaluer l'énergie électrique produite par un arc électrique dont la présence est détectée au sein d'une installation photovoltaïque 100.

Un arc électrique peut être lié à un défaut et se produire en tout endroit de l'installation 100, par exemple entre les modules photovoltaïques 1 et l'onduleur 2 (comme représenté par l'arc électrique 4 sur la figure 1), ou au sein d'un module photovoltaïque 1, ou encore sur une liaison reliant en série plusieurs modules photovoltaïques 1 (comme représenté par l'arc électrique 4' sur la figure 1). Un arc électrique peut également se produire en fonctionnement normal de l'installation 100, au sein d'un organe électromécanique, par exemple au sein d'un interrupteur sectionneur (non représenté sur la figure 1), à l'ouverture en charge des contacts de celui-ci. Dans ce cas, l'organe est doté de moyens d'extinction d'arc permettant d'éteindre rapidement l'arc électrique.

Un arc électrique, qu'il soit lié à un défaut ou non, provoque une variation importante de tension au sein de l'installation électrique 100. En effet, l'apparition de l'arc électrique se caractérise par un front ou saut positif de tension, d'une durée de l'ordre de quelques microsecondes et d'une amplitude égale à une tension d'arc initiale $V_{arc0}$ caractéristique. La valeur de cette tension d'arc initiale $V_{arc0}$ est typiquement comprise entre 12V et 35V. Elle dépend du matériau constituant les électrodes entre lesquelles l'arc électrique se forme. Par exemple, si les électrodes sont en cuivre, la tension d'arc initiale $V_{arc0}$ est égale, ou sensiblement égale, à 20V.

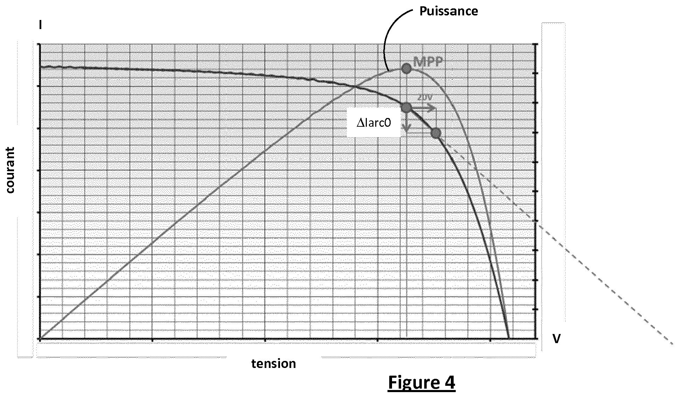

Lorsqu'un arc électrique apparaît dans l'installation photovoltaïque 100, qu'il s'agisse d'un arc électrique lié à un défaut (par exemple l'arc 4 ou 4') ou d'un arc électrique lié à l'ouverture en charge de l'interrupteur sectionneur, la tension aux bornes de chaque module photovoltaïque 1, ou d'une chaîne (ou « string ») de m modules 1 en série, augmente brutalement du fait de la tension d'arc initiale $V_{arc0}$ (dans l'hypothèse où l'arc se produit à l'extérieur du ou des modules considérés). La tension au bornes d'un string de m modules augmente de $V_{arc0}$ et la tension aux bornes de chaque module du string augmente de $V_{arc0}/m$. Considérons que m est égal à 20, alors l'apparition de l'arc électrique provoque une augmentation de 1V de la tension aux bornes de chaque module PV 1. Ce saut de tension occasionne une variation du point de fonctionnement des modules PV 1 et/ou du string. Il en résulte que courant I produit par l'installation photovoltaïque diminue brutalement d'une valeur $\Delta I_{arc0}$, comme cela ressort de la figure 4. Cette valeur $\Delta I_{arc0}$ dépend de la position du point de fonctionnement sur la courbe courant-tension, ou courbe caractéristique I-V, du ou des modules photovoltaïques. Sur la figure 4, on a représenté un saut de tension $V_{arc0}$ de 20V aux bornes d'un « string » de plusieurs modules photovoltaïques 1, fonctionnant au point MPP de puissance maximale, et le saut de courant $\Delta I_{arc0}$ correspondant, provoqués par l'apparition d'un arc électrique.

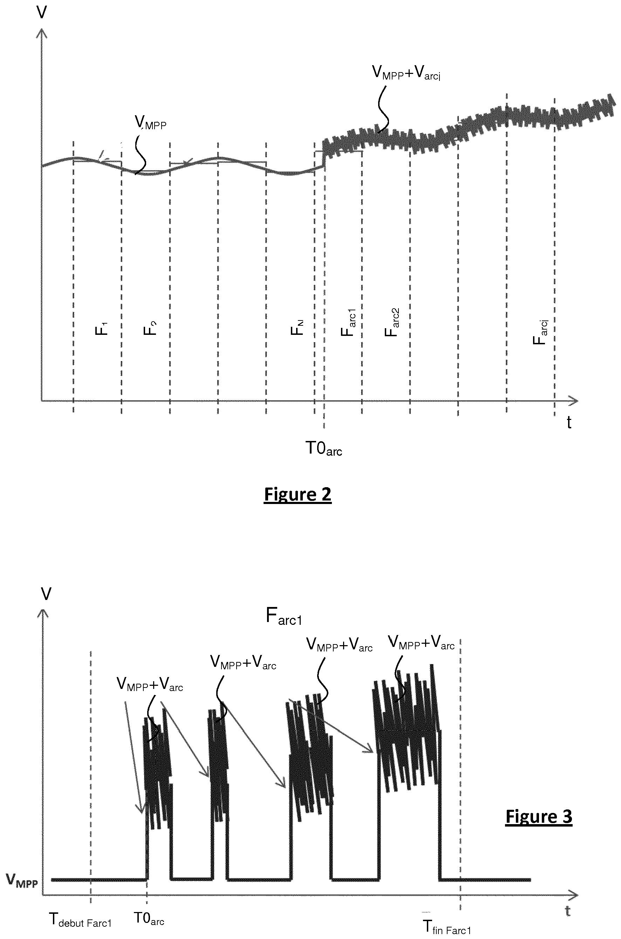

Sur la figure 2, on a représenté un premier exemple d'un signal de tension électrique V, aux bornes d'un ou plusieurs modules PV 1 de l'installation photovoltaïque 100 et mesuré par un capteur de mesure de tension 5. Ce signal intègre un saut de tension positif lié à l'apparition d'un arc électrique continu de longue durée provoqué par un défaut. Le signal de tension est décomposé en une succession de fenêtres d'acquisition notées :

- $F_i$, avec $1 \leq i \leq N$, avant apparition de l'arc, et
- $F_{arcj}$, avec $1 \leq j \leq n$, à compter de l'apparition de l'arc, n étant le nombre de fenêtres concomitantes à l'arc.

Sur la figure 3, on a représenté un deuxième exemple d'un signal de tension électrique V, produit par l'installation photovoltaïque 100 et mesuré par un capteur de mesure de tension. Le signal intègre un saut de tension positif lié à l'apparition d'un arc électrique discontinu comportant une succession de micro-arcs (c'est-à-dire d'arcs électriques de courte durée, typiquement comprise entre 2 $\mu$s et 100 $\mu$s) séparés par des périodes sans arc. Le signal de tension est décomposé en une succession de fenêtres d'acquisition. Sur la figure 3, seule la fenêtre d'acquisition contenant le début de l'arc électrique est représentée. Un arc électrique de ce type est généralement lié à un défaut de connexion (oxydation de contact, rupture de soudure, desserrage de bornier, etc.). En présence d'un tel défaut de connexion, des électrodes se forment mais restent par construction très proches l'une de l'autre, voire même en contact aléatoire, ce qui induit des connexions électriques aléatoires. Un arc électrique peut apparaître entre ces électrodes, durer quelques microsecondes à quelques centaines de microsecondes. Par fusion des matériaux d'électrode, un pont de soudure peut se créer, rétablissant ainsi le contact électrique entre les électrodes, puis se rompre à nouveau sous l'effet joule du courant provoquant ainsi l'apparition d'un nouvel arc de courte durée. Cette alternance d'apparition et de disparition d'arc de courte durée peut se répéter à plusieurs reprises et générer ainsi une succession d'arcs électriques de courtes durées séparés par des périodes sans arc.

L'installation photovoltaïque 100 comprend en outre un capteur 5 de mesure du tension électrique V aux bornes d'un ou plusieurs modules PV de l'installation 100, par exemple aux bornes d'une chaîne de m modules PV 1 (ou en variante aux bornes de chaque module PV 1), un capteur 11 de mesure de courant, un dispositif 7 de détection d'arc électrique, un dispositif 8 d'évaluation de l'énergie dégagée par un arc électrique détecté, et un dispositif 9 d'intervention ou de mise en sécurité. Plusieurs capteurs de mesure de tension peuvent être prévus pour mesurer les tensions en différents endroits de l'installation photovoltaïque. Par souci de clarté, on considère un seul capteur de mesure de tension 5 dans la description qui suit.

Le capteur 5 de mesure de tension fonctionne à une fréquence d'échantillonnage élevée, ici supérieure ou égale à 50 kHz. Dans l'exemple décrit ici, la fréquence d'échantillonnage est égale à 200 kHz. Le capteur de mesure 5 est relié à une mémoire tampon 6 de stockage du signal de tension mesuré.

Le capteur 11 de mesure de courant fonctionne ici avec une faible fréquence d'échantillonnage (inférieure ou égale à 1 Hz). Il est notamment destiné à fournir une ou plusieurs mesures du courant initial avant apparition d'un arc électrique détecté. Le signal de courant est également enregistré dans la mémoire tampon 6. Le capteur 11 est par exemple placé en entrée de l'onduleur 2.

Le dispositif 7 de détection d'arc électrique a pour fonction de détecter un arc électrique se produisant dans l'installation photovoltaïque 100. Il est adapté pour mettre en oeuvre une méthode de détection d'arc électrique, de préférence capable de détecter rapidement l'apparition d'un arc électrique, de préférence dans un délai maximal de quelques centaines de microsecondes après cette apparition. La méthode de détection peut par exemple reposer sur la détection d'un saut positif de tension, comme décrit par exemple dans le document brevet FR3002645. L'installation étant équipée du capteur 5 de mesure de tension haute fréquence, la détection d'arc électrique pourrait de façon avantageuse utiliser le signal de mesure de tension fourni par ce capteur 5.

Le dispositif 8 d'évaluation de l'énergie électrique produite par un arc électrique détecté a pour fonction d'évaluer la quantité d'énergie électrique produite par un arc électrique détecté par le dispositif de détection 8. Il comprend les modules suivants :

- un module 80 d'obtention d'un signal de tension électrique mesuré par le capteur 5 et du signal de courant mesuré par le capteur 11, relié à la mémoire 6 ;
- un module de traitement 81 apte à traiter le signal de tension et le signal de courant ;
- un module 82 d'évaluation du courant électrique pendant l'arc électrique ;
- un module 83 de détermination de l'énergie de l'arc par intégration dans le temps du produit de la tension mesurée et du courant évalué ;
- une unité de traitement ou de contrôle 84, en l'espèce un microprocesseur, à laquelle sont reliés tous les modules 80 à 83 et destinée à en contrôler le fonctionnement ;
- une mémoire 85.

Le module de traitement 81 est destiné, à partir du signal de tension mesuré, à déterminer :

o une tension initiale avant apparition de l'arc électrique ;
o des valeurs de tension pendant l'arc électrique.

Il est agencé pour décomposer le signal de tension en une pluralité de fenêtres d'acquisition $F_x$. Chaque fenêtre contient un nombre $N_f$ de points d'acquisition (c'est-à-dire de valeurs de tension mesurées/échantillonnées). Pour chaque fenêtre d'acquisition $F_x$, le module 81 calcule une valeur moyenne de la tension mesurée sur la fenêtre, notée $V_{Fx}$ pour la fenêtre $F_x$. Les valeurs moyennes de tension $V_{Fx}$ relatives aux fenêtres d'acquisition $F_x$ sont enregistrées dans la mémoire 85. Ainsi, les valeurs de tension pendant l'arc déterminées, notées $V_{Farcj}$, correspondent aux valeurs moyennes de tension calculées relatives aux fenêtres d'acquisition notées $F_{arcj}$ concomitantes à l'arc électrique.

Pour calculer la tension initiale avant l'arc, le module 81 calcule la moyenne des tensions $V_{Fi}$ déterminées sur plusieurs fenêtres d'acquisition $F_i$ avant l'arc, par exemple sur un nombre de fenêtres compris entre 10 et 20. Dans l'hypothèse où les modules PV 1 fonctionnent en leur point de puissance maximale avant apparition de l'arc, la tension initiale déterminée est égale ou sensiblement à la tension $V_{MPP}$ de ce point de puissance maximale (relative à un ou plusieurs modules PV en série). La tension initiale $V_{MPP}$ est enregistrée dans la mémoire 85.

Le module 82 est destiné à évaluer des valeurs de courant électrique produit par l'installation photovoltaïque 100 pendant l'arc électrique à partir d'un courant initial $I_0$ (avant l'arc) déterminé, de valeurs de tension pendant l'arc déterminées $V_{Farcj}$ et de la tension initiale déterminée, comme cela sera décrit dans la description du procédé.

Les modules 81, 82 et 83 sont des modules logiciels destinés à être exécutés par l'unité de traitement 84 pour la mise en oeuvre d'étapes du procédé d'évaluation qui sera décrit plus loin. L'unité de traitement 84 est également destinée à transmettre une commande de mise en sécurité au dispositif d'intervention 9, en cas de détection d'un arc électrique, notamment d'un arc électrique ayant dégagé une énergie critique.

Le dispositif d'intervention 9 a pour rôle d'interrompre un tel arc électrique, afin d'éviter tout risque de détérioration ou d'incendie. Le dispositif d'évaluation d'énergie 8 est relié au dispositif d'intervention 9 par une liaison de communication 10.

Le dispositif 7 de détection d'arc électrique, le dispositif 8 d'évaluation de l'énergie dégagée par l'arc électrique détecté et le dispositif d'intervention 9 forment un système de sécurité pour l'installation photovoltaïque 100.

On va maintenant décrire le procédé d'évaluation de l'énergie dégagée par un arc électrique détecté dans l'installation photovoltaïque 100, selon différents modes de réalisation.

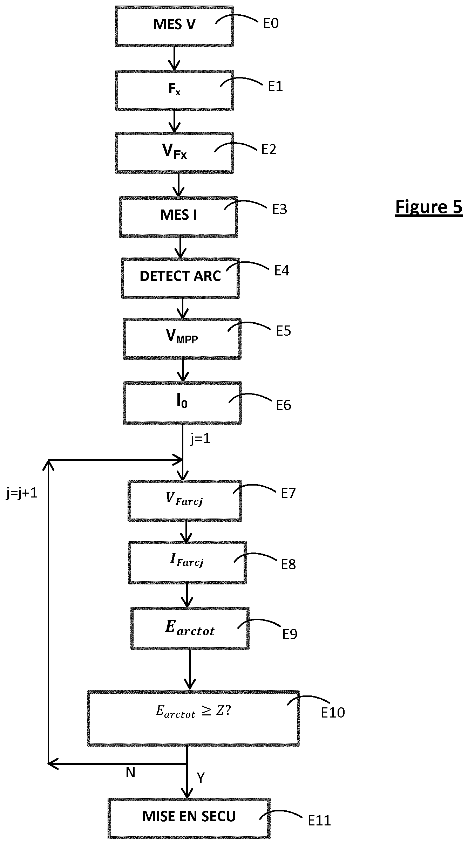

En référence à la figure 5, le procédé comprend une étape E0 d'acquisition ou de mesure, par le capteur de mesure 5, d'un signal de tension électrique V ici aux bornes d'une chaîne ou string de m modules photovoltaïques 1 de l'installation 100 avec une fréquence d'échantillonnage élevée, par exemple égale à 200 kHz. En variante, on pourrait mesurer la tension aux bornes d'un seul module PV ou de préférence aux bornes de chaque module PV. Le signal de tension mesuré est ici enregistré en mémoire 6 et peut ainsi être récupéré par le module 80 du dispositif d'évaluation d'énergie 8.

Le signal de tension V mesuré est décomposé en une succession de fenêtres d'acquisition $F_x$ lors d'une étape E1, par le module de traitement 81. Chaque fenêtre d'acquisition contient un nombre prédéfini $N_f$ de valeurs de tension mesurées et échantillonnées (ou points d'acquisition). Les fenêtres d'acquisition contient un nombre de points d'acquisition donné $N_f$ et donc une durée fixe, supérieure ou égale à 1 ms. Pour chaque fenêtre d'acquisition, le module de traitement 81 calcule une valeur moyenne de la tension mesurée sur la fenêtre, notée $V_{Fx}$, en faisant la moyenne des points d'acquisition de la fenêtre, lors d'une étape E2. Ces valeurs moyennes de tension $V_{Fx}$ sont stockées en mémoire 85.

Le procédé comprend également une étape E3 de mesure du courant, avec une faible fréquence d'échantillonnage, ici inférieure à 1 Hz. Les valeurs de courant mesurées sont enregistrées en mémoire 6.

Les étapes E0 à E3 peuvent être mises en oeuvre tout au long du fonctionnement de l'installation photovoltaïque 100.

Le procédé comprend également une étape E4 de détection d'un arc électrique, mise en oeuvre par le dispositif de détection d'arc 7. Cette étape de détection E4 vise à détecter un arc électrique se produisant dans l'installation photovoltaïque 100. Comme précédemment indiqué, la détection peut être basée sur toute méthode connue de détection d'arc électrique, de préférence adaptée pour détecter rapidement l'arc dans un délai maximal de quelques centaines de microsecondes après son apparition.

Supposons qu'un arc électrique, par exemple un arc électrique tel que celui représenté sur la figure 2, est détecté lors de l'étape E4. Notons $T0_{arc}$ l'instant d'apparition de l'arc électrique. A cet instant $T0_{arc}$, un saut positif de tension se produit dans le signal de tension, comme cela apparaît sur la figure 2. On note $F_i$, avec $1{\le}i{\le}N$, les fenêtres antérieures à l'apparition de l'arc, $F_{arc1}$, la fenêtre contenant un saut de tension lié à l'apparition de l'arc, et $F_{arcj}$, avec j allant de 2 à n, les fenêtres postérieures à l'apparition de l'arc et concomitantes à l'arc. On note par ailleurs $V_{Fi}$ la moyenne de la tension sur la fenêtre $F_i$ avant l'arc et $V_{Farcj}$ la moyenne de la tension sur la fenêtre $F_{arcj}$ après l'arc.

Suite à la détection E4 de l'arc électrique, le procédé comprend les étapes suivantes de :

- détermination E5 d'une tension initiale $V_{MPP}$ avant apparition de l'arc ;
- détermination E6 d'un courant électrique initial $I_0$ produit par l'installation 100 avant apparition de l'arc ;
- détermination E7 de valeurs de tension pendant l'arc, notées $V_{Farcj}$ avec j=1, 2, ...;
- évaluation E8 de valeurs de courant électrique produit par l'installation 100 pendant l'arc, notées $I_{Farcj}$ avec j=1, 2, ..., à partir du courant initial $I_0$, des valeurs de tension pendant l'arc déterminées $V_{Farcj}$ et de la tension initiale déterminée $V_{MPP}$,
- détermination E9 de l'énergie de l'arc $E_{arctot}$ par intégration dans le temps du produit de valeurs de tension d'arc, égales à la différence entre les valeurs de tension pendant l'arc $V_{Farcj}$ déterminées et la tension initiale $V_{MPP}$ déterminée, par des valeurs de courant évaluées.

On suppose ici que les modules PV 1 de l'installation photovoltaïque 100 fonctionnent en leur point de puissance maximale $V_{MPP}$ avant apparition de l'arc électrique. Pour déterminer la tension initiale $V_{MPP}$ (étape E5), le module de traitement 81 calcule ici la moyenne d'une pluralité de valeurs moyennes de tension $V_{Fi}$ relatives à une pluralité de fenêtres d'acquisition avant l'arc électrique. Par exemple, il calcule la moyenne d'une dizaine de valeurs de tension $V_{Fi}$ déterminées avant l'arc.

Le courant électrique initial $I_0$ déterminé (étape E6) est égal à une valeur de courant mesurée par le capteur 11 avant apparition de l'arc ou à la moyenne de plusieurs valeurs de courant mesurées par le capteur 11 avant apparition de l'arc.

Les valeurs de tension $V_{Farcj}$ déterminées pendant l'arc (étape E7) correspondent aux valeurs moyennes de tension relatives aux fenêtres $F_{arcj}$ pendant l'arc, stockées en mémoire 85. On suppose que chaque valeur de tension $V_{Farcj}$ est égale à la tension initiale avant l'arc, c'est-à-dire $V_{MPP}$, augmentée de la tension d'arc $V_{arcj}$. Autrement dit, on fait l'hypothèse que :

$$V_{Farcj} = V_{MPP} + V_{arcj} .$$

Lors de l'étape E8, on évalue une valeur de courant $I_{Farcj}$ pour chaque fenêtre $F_{arcj}$ concomitante à l'arc électrique. A cet effet, on soustrait au courant initial $I_0$ (avant apparition de l'arc) la valeur de tension d'arc $V_{arcj}$ relative à la fenêtre $F_{arcj}$ multipliée par le rapport entre l'amplitude (en valeur absolue) d'un saut de courant $|\Delta I_{arc0}|$ lié à l'apparition de l'arc et l'amplitude d'un saut de tension $\Delta V_{arc0}$ lié à l'apparition de l'arc. La tension d'arc $V_{arcj}$ est égale à la différence entre la tension $V_{Farcj}$ déterminée pour la fenêtre $F_{arcj}$ et la tension initiale $V_{MPP}$ déterminée. Ainsi, on calcule une évaluation du courant $I_{Farcj}$ pour chaque fenêtre $F_{arcj}$ par la relation suivante :

$$I_{Farcj} = I_0 - \left(V_{Farcj} - V_{MPP}\right) \times \frac{|\Delta I_{arc0}|}{\Delta V_{arc0}} = I_0 - V_{arcj} \times \frac{|\Delta I_{arc0}|}{\Delta V_{arc0}}$$

Ainsi, on considère que le courant $I_{Farcj}$, après apparition de l'arc, varie de façon linéaire en fonction de la tension $V_{Farcj}$, selon la demi-droite représentée sur la figure 4. Les valeurs de courant évaluées sont enregistrées en mémoire 85.

La valeur de tension d'arc $V_{arcj}$ relative à la fenêtre $F_{arcj}$ est égale à la différence entre la tension $V_{Farcj}$ déterminée pour la fenêtre $F_{arcj}$ et la tension initiale déterminée $V_{MPP}$.

L'amplitude du saut de tension $\Delta V_{arc0}$ a une valeur connue, comme précédemment explicité. En l'espèce, on suppose que $\Delta V_{arc0}$ est égale à 20 V (pour un string de modules PV).

Selon l'invention, on considère ici que l'amplitude du saut de courant $|\Delta I_{arc0}|$ est égale à un pourcentage prédéfini de x% du courant initial $I_0$, c'est-à-dire du courant initial circulant dans la chaîne de modules photovoltaïques concernée par l'arc électrique au point de fonctionnement de l'installation photovoltaïque. La valeur de x dépend de la position du point de fonctionnement sur la courbe IV au moment où se produit l'arc électrique. Elle peut être extrapolée à partir de mesures de courbes IV ou déduite pour une installation photovoltaïque donnée de courbes IV prédéfinies relatives aux modules photovoltaïques de l'installation. Elle est par exemple comprise entre 6% et 8%. On suppose ici qu'elle est égale à 7%.

L'intégration dans le temps du produit de la tension d'arc et du courant pendant l'arc (étape E9) peut être mise en oeuvre de différentes façons.

Dans un premier mode de réalisation, pour calculer l'énergie totale produite par l'arc électrique, on calcule :

- une tension d'arc moyenne $V_{arctot}$, en calculant la moyenne d'une pluralité de valeurs de tension d'arc déterminées relatives à une pluralité $N_{Farc}$ de fenêtres d'acquisition couvrant l'arc électrique,
- un courant moyen $I_{arctot}$ pendant l'arc électrique, en calculant la moyenne d'une pluralité de valeurs de courant évaluées pour la pluralité $N_{Farc}$ de fenêtres d'acquisition ;
- l'énergie totale produite par l'arc $E_{arctot}$ par la relation : $E_{arctot} = V_{arctot} \times I_{arctot} \times n \times \frac{1}{F_{ech}} \times N_f$ $N_f$ où $n$, $F_{ech}$ et $N_f$ représentent respectivement le nombre de fenêtres d'acquisition pendant l'arc, la fréquence d'échantillonnage de la tension mesurée et le nombre de points d'acquisition dans une fenêtre d'acquisition.

La tension d'arc moyenne $V_{arctot}$ est par exemple calculée par la relation suivante :

$$V_{arctot} = \frac{V_{arc1} + \sum_{F_{arc2}}^{F_{arcn}}\left(V_{Farcj} - V_{MPP}\right)}{n}$$

Pour calculer la tension d'arc moyenne de la fenêtre $F_{arc1}$ contenant le saut de tension lié à l'apparition de l'arc, on peut calculer la différence entre la tension moyenne après le front (ou saut) de tension dans la fenêtre d'arc $F_{arc1}$ et la tension moyenne avant le front de tension dans la fenêtre d'arc $F_{arc1}$.

Le courant moyen $I_{arctot}$ est calculé en faisant la moyenne des valeurs de courant évaluées pour les fenêtres d'acquisition pendant l'arc par la relation :

$$I_{arctot} = \frac{\sum_{F_{arc1}}^{F_{arcn}} I_{Farcj}}{n}$$

Dans un deuxième mode de réalisation, pour calculer l'énergie totale produite par l'arc électrique, on calcule :

- l'énergie d'arc produite par l'arc pendant chaque fenêtre d'acquisition d'indice « arcj » par la relation
$$E_{Farcj} = V_{arcj} \times I_{Farcj} \times \frac{1}{F_{ech}} \times N_f ;$$

- la somme des énergies d'arc produites sur une pluralité n de fenêtres d'acquisition couvrant l'arc électrique par la relation $E_{arctot} = \sum_{F_{arc1}}^{F_{arcn}} E_{Farcj}$.

Pour calculer l'énergie d'arc relative à la fenêtre $F_{arc1}$ contenant le saut de tension lié à l'apparition de l'arc, on peut estimer la tension d'arc $V_{arc1}$ en faisant la différence entre la tension moyenne après le front (ou saut) de tension dans la fenêtre d'arc $F_{arc1}$ et la tension moyenne avant le front de tension dans la fenêtre d'arc $F_{arc1}$.

Dans les modes de réalisation qui viennent d'être décrit, le courant électrique pendant l'arc est évalué, par reconstruction linéaire, à partir du courant initial mesuré et de valeurs de tension pendant l'arc déterminées. Ainsi, l'évaluation du niveau d'énergie de l'arc est basée sur une mesure de tension haute fréquence (supérieure ou égale à 50 kHz) adjointe à une reconstruction linéaire du courant.

Dans une variante de réalisation, les valeurs de courant pendant l'arc évaluées sont des valeurs mesurées au moyen d'un capteur de mesure de courant (tel que le capteur 111) avec une fréquence d'échantillonnage inférieure ou égale à 1 Hz. Dans ce cas, la valeur du courant $I_{Farcj}$ relative à la fenêtre $F_{arcj}$ est égale à une valeur de courant mesurée sur un point de la fenêtre $F_{arcj}$. Ainsi, l'évaluation du niveau d'énergie de l'arc est basée sur une mesure de tension haute fréquence (supérieure ou égale à 50 kHz) adjointe à une évaluation du courant faite par une mesure de courant à faible fréquence d'échantillonnage (inférieure ou égale à 1 Hz), de type « monitoring ».

L'étape E9 d'évaluation de l'énergie $E_{arctot}$ générée ou produite par l'arc électrique peut être suivie d'une étape de test E10 permettant de vérifier si l'énergie d'arc totale est supérieure ou égale à un seuil d'énergie critique Z (par exemple exprimé en Joules). Autrement dit, lors de l'étape E10, on réalise le test suivant :

$$E_{arctot} \geq Z?$$

Par exemple, le seuil Z est ici égal à 2 Joules. On pourrait toutefois adapter la valeur de ce seuil, en fonction de l'installation et de son environnement.

Si le test E10 est positif, l'énergie d'arc totale ayant atteint ou dépassé le seuil Z, le dispositif d'évaluation d'énergie 8 envoie automatiquement au dispositif d'intervention 9 une commande de mise en sécurité de l'installation 100. Puis, lors d'une étape E11, le dispositif d'intervention 9 met en sécurité l'installation photovoltaïque 100. Cette mise en sécurité peut reposer sur des interrupteurs commandés à distance. Elle peut consister en un ordre d'interruption du fonctionnement de l'installation photovoltaïque, ce qui permet de stopper l'arc électrique parasite et de supprimer tout risque de dégradation et/ou de début d'incendie.

Si le test E10 est négatif, l'énergie d'arc totale étant inférieure au seuil Z, le procédé continue d'évaluer l'énergie totale produite par l'arc électrique, pour une fenêtre d'acquisition suivante (j=j+1).

En variante, on pourrait définir différents niveaux de criticité de l'arc électrique, par exemple :

- « niveau 1 » correspondant à une énergie totale d'arc $E_{arctot}$ strictement inférieure à 1 Joules ;
- « niveau 2 » correspondant à une énergie totale d'arc $E_{arctot}$ supérieure ou égale à 1 Joules et strictement inférieure à 2 Joules ;
- « niveau 3 » correspondant à une énergie totale d'arc $E_{arctot}$ supérieure strictement à 2 Joules.

Le niveau 1 correspond à un arc électrique sans risque de sécurité. Le dispositif d'évaluation 8 peut éventuellement signaler la présence d'un arc électrique sans risque de sécurité à un opérateur. Celui-ci peut décider de ne pas activer d'alerte pour ce niveau.

Le niveau 2 correspond à un arc électrique sans risque de sécurité immédiat mais qui pourrait éventuellement devenir dangereux. Dans ce cas, le dispositif d'évaluation 8 signale à l'opérateur la présence d'un arc électrique sans risque de sécurité immédiat mais nécessitant une intervention rapide pour identifier le défaut à l'origine de l'arc et le corriger.

Le niveau 3 correspond à un arc électrique dangereux. Le dispositif d'évaluation 8 commande une mise en sécurité immédiate de l'installation photovoltaïque 100 au dispositif d'intervention 9, comme précédemment décrit.

Dans le mode de réalisation qui vient d'être décrit, l'arc électrique détecté est un arc continu de longue durée. En variante, l'arc électrique détecté peut être discontinu. Il comprend une succession de micro-arcs séparés par des périodes sans arc. Sur la figure 3, on a représenté un exemple d'arc électrique discontinu durant une fenêtre d'acquisition, en l'espèce la fenêtre contenant les premiers micro-arcs. Dans ce cas, les étapes E7 à E9 sont mises en oeuvre pour chaque micro-arc. Le dispositif d'évaluation d'énergie 8 identifie les micro-arcs et détermine la valeur moyenne de la tension mesurée durant chaque micro-arc puis évalue la valeur de courant correspondante. Puis il évalue l'énergie de chaque micro-arc. Le dispositif 8 stocke en mémoire les énergies évaluées relatives aux micro-arcs identifiés puis somme ces énergies afin d'obtenir l'énergie totale générée par l'arc électrique. Le test E10 est ensuite mis en oeuvre afin le cas échéant de commander une mise en sécurité de l'installation photovoltaïque 100.

**Revendications**

1. Procédé d'évaluation de l'énergie électrique produite par un arc électrique dans une installation photovoltaïque (100) comprenant les étapes suivantes :

   A) Mesure (E0) d'un signal de tension électrique aux bornes d'au moins un module photovoltaïque de l'installation (100) avec une fréquence d'échantillonnage supérieure ou égale à 50 kHz et, à partir du signal de tension mesuré :

   o Détermination d'une tension initiale avant apparition de l'arc ;
   o Détermination de valeurs de tension pendant l'arc électrique ;

   B) Evaluation de valeurs de courant électrique produit par l'installation photovoltaïque pendant l'arc électrique ;
   C) Intégration (E7) dans le temps du produit de valeurs de tension d'arc égales à la différence entre les valeurs de tension pendant l'arc et la tension initiale, déterminées lors de l'étape A), par des valeurs de courant évaluées lors de l'étape B), afin de déterminer l'énergie de l'arc.

2. Procédé selon la revendication précédente, **caractérisé en ce que**, pour évaluer une valeur de courant pendant l'arc, on détermine un courant électrique initial avant l'arc électrique et on soustrait audit courant initial une valeur de tension d'arc, égale à la différence entre une valeur de tension déterminée lors de l'étape A) et la tension initiale, multipliée par le rapport entre l'amplitude d'un saut de courant lié à l'apparition de l'arc et l'amplitude d'un saut de tension lié à l'apparition de l'arc.

3. Procédé selon la revendication précédente, **caractérisé en ce que** l'amplitude du saut de courant est égale à un pourcentage prédéfini de x% du courant initial, x étant compris entre 6% et 8%, notamment égal à 7%.

4. Procédé selon l'une des revendications précédentes, **caractérisé en ce que** l'amplitude du saut de tension est prédéfinie et comprise entre 12V et 35V, notamment égale à 20V.

5. Procédé selon la revendication 1, **caractérisé en ce que** les valeurs de courant pendant l'arc évaluées sont des valeurs mesurées avec une fréquence d'échantillonnage inférieure ou égale à 1Hz.

6. Procédé selon l'une des revendications 1 à 3, **caractérisé en ce qu'**il comprend une étape (E1) de décomposition du signal de tension en une pluralité de fenêtres d'acquisition ($F_x$; $F_i$, $F_{arcj}$), chaque fenêtre contenant un nombre $N_f$ de points d'acquisition correspondant à des valeurs de tension échantillonnées, et, pour chaque fenêtre d'acquisition, une étape (E5) de détermination d'une valeur moyenne de la tension mesurée sur ladite fenêtre.

7. Procédé selon la revendication précédente, **caractérisé en ce qu'**on détermine la tension initiale avant apparition de l'arc en calculant une moyenne d'une pluralité de valeurs moyennes de tension relatives à une pluralité de fenêtres d'acquisition avant l'arc électrique.

8. Procédé selon l'une des revendications précédentes, **caractérisé en ce que** les valeurs de tension déterminées pendant l'arc électrique sont égales à des valeurs moyennes de tension relative à une succession de fenêtres d'acquisition.

9. Procédé selon l'une des revendications 4 à 6, **caractérisé en ce qu'**on calcule :

   • une tension d'arc moyenne $V_{arctot}$, en calculant la moyenne d'une pluralité de valeurs de tension d'arc déterminées relatives à une pluralité n de fenêtres d'acquisition couvrant l'arc électrique,
   • un courant moyen $I_{arctot}$ pendant l'arc électrique, en calculant la moyenne d'une pluralité de valeurs de courant évaluées pour la pluralité n de fenêtres d'acquisition ;

   • l'énergie totale produite par l'arc $E_{arctot}$ par la relation : $E_{arctot} = V_{arctot} \times I_{arctot} \times n \times \frac{1}{F_{ech}} \times N_f$ où $n$, $F_{ech}$ et $N_f$ représentent respectivement le nombre de fenêtres d'acquisition pendant l'arc, la fréquence d'échantillonnage de la tension mesurée et le nombre de points d'acquisition dans une fenêtre d'acquisition.

10. Procédé selon l'une des revendications 4 à 6, **caractérisé en ce qu'**on calcule :

• l'énergie d'arc produite par l'arc pendant chaque fenêtre d'acquisition d'indice arcj par la relation

$$E_{Farcj} = V_{arcj} \times I_{Farcj} \times \frac{1}{F_{ech}} \times N_f$$ où $V_{arej}$, $I_{Farej}$, $F_{ech}$ et $N_f$ représentent respectivement une tension d'arc moyenne calculée pour la fenêtre d'indice arcj, un courant moyen évalué pour la fenêtre d'indice arcj, la fréquence d'échantillonnage de la tension mesurée et le nombre de points d'acquisition dans une fenêtre d'acquisition ;

• l'énergie totale produite par l'arc $E_{arctot}$ en faisant la somme des énergies d'arc produites sur une pluralité n de fenêtres d'acquisition couvrant l'arc électrique.

11. Procédé selon l'une des revendications précédentes, **caractérisé en ce que**, dans le cas d'un arc électrique discontinu comportant une pluralité de micro-arcs, on détermine l'énergie de chaque micro-arc électrique, puis on fait la somme des énergies respectives des micro-arcs électriques afin de déterminer l'énergie de l'arc électrique discontinu.

12. Procédé selon l'une des revendications précédentes, **caractérisé en ce qu'**il comprend une étape (E10) de comparaison de l'énergie de l'arc électrique déterminée avec un seuil d'énergie et une étape (E11) de mise en sécurité en cas de dépassement dudit seuil.

13. Dispositif d'évaluation de l'énergie dégagée par un arc électrique dans une installation photovoltaïque (100) **caractérisé en ce qu'**il comprend :

- un module (80) d'obtention d'un signal de tension électrique mesuré aux bornes d'au moins un module photovoltaïque de l'installation (100) avec une fréquence d'échantillonnage supérieure ou égale à 50 kHz ;
- un module de détermination d'un courant électrique initial produit par l'installation photovoltaïque avant apparition de l'arc ;
- un module (81) de traitement du signal de tension adapté pour déterminer, à partir du signal de tension mesuré :

  o une tension initiale avant apparition de l'arc ;
  o des valeurs de tension pendant l'arc électrique ;

- un module d'évaluation de valeurs de courant électrique produit par l'installation photovoltaïque pendant l'arc électrique;
- un module d'intégration dans le temps du produit de valeurs de tension d'arc égales à la différence entre les valeurs de tension pendant l'arc et la tension initiale déterminées par le module de traitement, par des valeurs de courant évaluées par le module d'évaluation, afin de déterminer l'énergie de l'arc.

14. Système de sécurité pour une installation photovoltaïque, **caractérisé en ce qu'**il comprend un dispositif (7) de détection d'un arc électrique, un dispositif (8) d'évaluation de l'énergie électrique produite par un arc électrique détecté, selon la revendication 13, et un dispositif d'intervention (9) destiné à mettre l'installation photovoltaïque en sécurité.

15. Installation photovoltaïque, **caractérisée en ce qu'**elle comprend un système de sécurité selon la revendication précédente.


**Patentansprüche**

1. Verfahren zur Beurteilung der von einem Lichtbogen in einer Fotovoltaikanlage (100) erzeugten elektrischen Energie, umfassend die folgenden Schritte:

A) Messen (E0) eines Signals einer elektrischen Spannung an den Klemmen mindestens eines Fotovoltaikmoduls der Anlage (100) mit einer Bemusterungsfrequenz kleiner oder gleich 50 kHz und auf Basis des gemessenen Spannungssignals:

  o Bestimmung einer Anfangsspannung vor Erscheinen des Lichtbogens;
  o Bestimmung von Spannungswerten während des Lichtbogens;

B) Beurteilung von Werten von elektrischem Strom, der von der Fotovoltaikanlage während des Lichtbogens erzeugt wird;

C) zeitliche Integration (E7) des Produkts aus den Lichtbogenspannungswerten gleich der Differenz zwischen den Spannungswerten während des Lichtbogens und der Anfangsspannung, die in Schritt A) bestimmt wurden, und Stromwerten, die in Schritt B) beurteilt wurden, um die Energie des Lichtbogens zu bestimmen.

2. Verfahren nach dem vorhergehenden Anspruch, **dadurch gekennzeichnet, dass** zur Beurteilung eines Stromwerts während des Lichtbogens ein elektrischer Anfangsstrom vor dem Lichtbogen bestimmt wird, und von dem Anfangsstrom ein Lichtbogenspannungswert gleich der Differenz zwischen einem in Schritt A) bestimmten Spannungswert und der Anfangsspannung abgezogen wird, multipliziert mit dem Verhältnis zwischen der Amplitude eines Stromsprungs in Verbindung mit dem Erscheinen des Lichtbogens und der Amplitude eines Spannungssprungs in Verbindung mit dem Erscheinen des Lichtbogens.

3. Verfahren nach dem vorhergehenden Anspruch, **dadurch gekennzeichnet, dass** die Amplitude des Stromsprungs gleich einem vordefinierten Prozentsatz von x% des Anfangsstroms ist, wobei x zwischen 6% und 8% beträgt, insbesondere gleich 7% ist.

4. Verfahren nach einem der vorhergehenden Ansprüche, **dadurch gekennzeichnet, dass** die Amplitude des Spannungssprungs zwischen 12V und 35V, insbesondere gleich 20V, vordefiniert und angesiedelt ist.

5. Verfahren nach Anspruch 1, **dadurch gekennzeichnet, dass** die beurteilten Stromwerte während des Lichtbogens Werte sind, die mit einer Bemusterungsfrequenz kleiner oder gleich 1 Hz gemessen werden.

6. Verfahren nach einem der Ansprüche 1 bis 3, **dadurch gekennzeichnet, dass** es einen Schritt (E1) der Zerlegung des Spannungssignals in eine Vielzahl von Erfassungsfenstern ($F_x$; $F_i$; $F_{arcj}$) umfasst, wobei jedes Fenster eine Anzahl $N_f$ von Erfassungspunkten enthält, die bemusterten Spannungswerten entsprechen, und für jedes Erfassungsfenster einen Schritt (E5) der Bestimmung eines Durchschnittswerts der an dem Fenster gemessenen Spannung umfasst.

7. Verfahren nach dem vorhergehenden Anspruch, **dadurch gekennzeichnet, dass** die Anfangsspannung vor Erscheinen des Lichtbogens bestimmt wird, wobei ein Durchschnitt einer Vielzahl von Spannungswerten in Zusammenhang mit einer Vielzahl von Erfassungsfenstern vor dem Lichtbogen berechnet wird.

8. Verfahren nach einem der vorhergehenden Ansprüche, **dadurch gekennzeichnet, dass** die während des Lichtbogens bestimmten Spannungswerte gleich Durchschnittswerten einer Spannung in Zusammenhang mit einer Aufeinanderfolge von Erfassungsfenstern sind.

9. Verfahren nach einem der Ansprüche 4 bis 6, **dadurch gekennzeichnet, dass** berechnet werden:

   • eine durchschnittliche Lichtbogenspannung $V_{arctot}$, wobei der Durchschnitt einer Vielzahl von bestimmten Lichtbogenspannungswerten in Zusammenhang mit einer Vielzahl $n$ von den Lichtbogen abdeckenden Erfassungsfenstern berechnet wird,

   • ein durchschnittlicher Strom $I_{arctot}$ während des Lichtbogens, wobei der Durchschnitt einer Vielzahl von beurteilten Stromwerten für die Vielzahl $n$ von Erfassungsfenstern berechnet wird;

   • die von dem Lichtbogen $E_{arctot}$ erzeugte Gesamtenergie durch das Verhältnis: $E_{arctot} = V_{arctot} \times I_{arctot} \times n \times 1/F_{ech} \times Nf$, wobei $n$, $F_{ech}$ und $Nf$ die Anzahl von Erfassungsfenstern während des Lichtbogens, die Bemusterungsfrequenz der gemessenen Spannung bzw. die Anzahl von Erfassungspunkten in einem Erfassungsfenster darstellen.

10. Verfahren nach einem der Ansprüche 4 bis 6, **dadurch gekennzeichnet, dass** berechnet werden:

   • die von dem Lichtbogen während jedes Erfassungsfensters mit dem Index arcj erzeugte Energie durch das Verhältnis: $E_{Farcj} = V_{arcj} \times I_{Farcj} \times 1/Fech \times Nf$, wobei $V_{arcj}$, $I_{Farcj}$, $Fech$ und $Nf$ einen beurteilten Durchschnittstrom für das Fenster mit dem Index arcj, die Bemusterungsfrequenz der gemessenen Spannung bzw. die Anzahl von Erfassungspunkten in einem Erfassungsfenster darstellen;

   • die vom Lichtbogen $E_{arctot}$ erzeugte Gesamtenergie, wobei die Summe der Lichtbogenenergien erstellt wird, die an einer Vielzahl n von Erfassungsfenstern, die den Lichtbogen abdecken, erzeugt werden.

**11.** Verfahren nach einem der vorhergehenden Ansprüche, **dadurch gekennzeichnet, dass** im Falle eines diskontinuierlichen Lichtbogens, umfassend eine Vielzahl von Mikrolichtbögen, die Energie jedes Mikrolichtbogens bestimmt wird, dann die Summe der jeweiligen Energien der Mikrolichtbögen erstellt wird, um die Energie des diskontinuierlichen Lichtbogens zu bestimmen.

**12.** Verfahren nach einem der vorhergehenden Ansprüche, **dadurch gekennzeichnet, dass** es einen Schritt (E10) des Vergleichs der bestimmten Energie des Lichtbogens mit einem Energiegrenzwert und einen Schritt (E11) der Sicherung im Falle einer Überschreitung des Grenzwerts umfasst.

**13.** Vorrichtung zur Beurteilung der von einem Lichtbogen in einer Fotovoltaikanlage (100) erzeugten Energie, **dadurch gekennzeichnet, dass** sie umfasst:

- ein Modul (80) zum Erhalt eines gemessenen Signals einer elektrischen Spannung an den Klemmen mindestens eines Fotovoltaikmoduls der Anlage (100) mit einer Bemusterungsfrequenz kleiner oder gleich 50 kHz;
- ein Modul zur Bestimmung eines elektrischen Anfangsstroms, der von der Fotovoltaikanlage vor Erscheinen des Lichtbogens erzeugt wird;
- ein Modul (81) zur Bearbeitung des Spannungssignals, das dazu vorgesehen ist, auf Basis des gemessenen Spannungssignals zu bestimmen:

  o eine Anfangsspannung vor Erscheinen des Lichtbogens;
  o Spannungswerte während des Lichtbogens;

- ein Modul zur Beurteilung von Werten von elektrischem Strom, der von der Fotovoltaikanlage während des Lichtbogens erzeugt wird;
- ein Modul zur zeitlichen Integration des Produkts aus den Lichtbogenspannungswerten gleich der Differenz zwischen den Spannungswerten während des Lichtbogens und der Anfangsspannung, die von dem Bearbeitungsmodul bestimmt wurden, und Stromwerten, die von dem Beurteilungsmodul beurteilt wurden, um die Energie des Lichtbogens zu bestimmen.

**14.** Sicherungssystem für eine Fotovoltaikanlage, **dadurch gekennzeichnet, dass** es eine Vorrichtung (7) zur Erfassung eines Lichtbogens, eine Vorrichtung (8) zur Beurteilung der von dem erfassten Lichtbogen erzeugten elektrischen Energie nach Anspruch 13 und eine Interventionsvorrichtung (9) umfasst, die dazu bestimmt ist, die Fotovoltaikanlage zu sichern.

**15.** Fotovoltaikanlage, **dadurch gekennzeichnet, dass** sie ein Sicherungssystem nach dem vorhergehenden Anspruch umfasst.

**Claims**

**1.** A method for evaluating the electrical energy produced by an electric arc in a photovoltaic installation (100), comprising the following steps:

A) Measuring (E0) an electric voltage signal across the terminals of at least one photovoltaic module of the installation (100) at a sampling frequency greater than or equal to 50 kHz and, from the measured voltage signal:

o Determining an initial voltage before the arc appears;
o Determining voltage values during the electric arc;

B) Evaluating values of electric current produced by the photovoltaic installation during the electric arc;
C) Integrating (E7), over time, the product of arc voltage values that are equal to the difference between the voltage values during the arc and the initial voltage, which values are determined in step A), and current values evaluated in step B), in order to determine the energy of the arc.

**2.** The method as claimed in the preceding claim, **characterized in that**, to evaluate a current value during the arc, an initial electric current before the electric arc is determined, and there is subtracted, from said initial current, an arc voltage value, which is equal to the difference between a voltage value determined in step A) and the initial voltage, multiplied by the ratio between the magnitude of a current jump linked to the appearance of the arc and the magnitude of a voltage jump linked to the appearance of the arc.

3. The method as claimed in the preceding claim, **characterized in that** the magnitude of the current jump is equal to a predefined percentage of x% of the initial current, x being between 6% and 8%, in particular equal to 7%.

4. The method as claimed in one of the preceding claims, **characterized in that** the magnitude of the voltage jump is predefined and between 12 V and 35 V, in particular equal to 20 V.

5. The method as claimed in claim 1, **characterized in that** the evaluated current values during the arc are values measured at a sampling frequency less than or equal to 1 Hz.

6. The method as claimed in one of claims 1 to 3, **characterized in that** it comprises a step (E1) of breaking down the voltage signal into a plurality of acquisition windows ($F_x$; $F_i$, $F_{arcj}$), each window containing a number $N_f$ of acquisition points corresponding to sampled voltage values, and, for each acquisition window, a step (E5) of determining an average value of the voltage measured over said window.

7. The method as claimed in the preceding claim, **characterized in that** the initial voltage before the arc appears is determined by calculating an average of a plurality of average voltage values in relation to a plurality of acquisition windows before the electric arc.

8. The method as claimed in one of the preceding claims, **characterized in that** the voltage values determined during the electric arc are equal to average voltage values in relation to a succession of acquisition windows.

9. The method as claimed in one of claims 4 to 6, **characterized in that** the following are calculated:

   • an average arc voltage $V_{arctot}$, by calculating the average of a plurality of determined arc voltage values in relation to a plurality n of acquisition windows covering the electric arc,
   • an average current $I_{arctot}$ during the electric arc, by calculating the average of a plurality of current values evaluated for the plurality n of acquisition windows;
   • the total energy produced by the arc $E_{arctot}$ using the relationship: $E_{arctot} =$

   $V_{arctot} \times I_{arctot} \times n \times \dfrac{1}{F_{ech}} \times N_f$ where $n$, $F_{ech}$ and $N_f$ represent the number of acquisition windows during the arc, the sampling frequency of the measured voltage and the number of acquisition points in an acquisition window, respectively.

10. The method as claimed in one of claims 4 to 6, **characterized in that** the following are calculated:

   • the arc energy produced by the arc during each acquisition window of index arcj using the relationship

   $E_{Farcj} = V_{arcj} \times I_{Farcj} \times \dfrac{1}{F_{ech}} \times N_f$ where $V_{arcj}$, $I_{Farcj}$, $F_{ech}$ and $N_f$ represent an average arc voltage calculated for the window of index arcj, an average current evaluated for the window of index arcj, the sampling frequency of the measured voltage and the number of acquisition points in an acquisition window, respectively;
   • the total energy produced by the arc $E_{arctot}$ by summing the arc energies produced over a plurality n of acquisition windows covering the electric arc.

11. The method as claimed in one of the preceding claims, **characterized in that**, in the event of a discontinuous electric arc including a plurality of micro-arcs, the energy of each electric micro-arc is determined, and then the respective energies of the electric micro-arcs are summed in order to determine the energy of the discontinuous electric arc.

12. The method as claimed in one of the preceding claims, **characterized in that** it comprises a step (E10) of comparing the determined energy of the electric arc with an energy threshold, and a protection step (E11) if this threshold is exceeded.

13. A device for evaluating the energy released by an electric arc in a photovoltaic installation (100), **characterized in that** it comprises:

   - a module (80) for obtaining an electric voltage signal measured across the terminals of at least one photovoltaic module of the installation (100) at a sampling frequency greater than or equal to 50 kHz;
- a module for determining an initial electric current produced by the photovoltaic installation before the arc appears;
- a module (81) for processing the voltage signal, designed to determine, from the measured voltage signal:

  o an initial voltage before the arc appears;
  o voltage values during the electric arc;

- a module for evaluating values of electric current produced by the photovoltaic installation during the electric arc;
- a module for integrating, over time, the product of arc voltage values that are equal to the difference between the voltage values during the arc and the initial voltage, which values are determined by the processing module, and current values evaluated by the evaluation module, in order to determine the energy of the arc.

14. A safety system for a photovoltaic installation, **characterized in that** it comprises a device (7) for detecting an electric arc, a device (8) for evaluating the electrical energy produced by a detected electric arc, as claimed in claim 13, and an intervention device (9) intended to protect the photovoltaic installation.

15. A photovoltaic installation, **characterized in that** it comprises a safety system as claimed in the preceding claim.

**Figure 1**

**Figure 2**

**Figure 3**

Figure 4

**Figure 5**

Figure 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3002645

**Littérature non-brevet citée dans la description**

- **X. YAO et al.** *Applied Power Electronics Conférence and Exhibition, 2012, Twenty-seventh annual IEEE,* 2012, 1720-1727
- **K. KOZIZ et al.** *IEEE Transactions on Power Delivery,* 2013, vol. 28 (3), 1584-1591